# EUROPÄISCHE PATENTSCHRIFT

(11) **EP 2 005 572 B1**
(45) Veröffentlichungstag und Bekanntmachung des Hinweises auf die Patenterteilung: **10.10.2018**
(21) Anmeldenummer: 07722886.4
(22) Anmeldetag: 21.02.2007
(51) Int. Cl.: H03B 5/12

(54) **OSZILLATOR MIT MITGEFÜHRTEM VERSTÄRKER**
OSCILLATOR COMPRISING AN INCORPORATED AMPLIFIER
OSCILLATEUR À AMPLIFICATEUR EMBARQUÉ

(30) Priorität: 01.03.2006 DE 102006009467
(43) Veröffentlichungstag der Anmeldung: 24.12.2008
(73) Patentinhaber: Rohde & Schwarz GmbH & Co. KG, 81671 München (DE)
(72) Erfinder: KAHMEN, Gerhard, 82041 Deisenhofen (DE)
(74) Vertreter: Körfer, Thomas
(86) Internationale Anmeldenummer: PCT/EP2007/001510
(87) Internationale Veröffentlichungsnummer: WO 2007/101553

(56) Entgegenhaltungen:
- EP-A- 1 223 667
- GB-A- 2 274 562
- US-A- 4 638 264
- US-A- 5 055 889

## Beschreibung

Die Erfindung betrifft einen Oszillator, insbesondere für Mikrowellen-Schaltungen.

Ein solcher Oszillator ist beispielsweise aus der US 2005/0270114 A1 bekannt.

Die GB 2 274 562 A bildet den Oberbegriff des Patenanspruchs 1. Dieses Dokument offenbart einen spannungsgesteuerten Oszillator, welcher über zwei abstimmbare Elemente verfügt. Dabei ist das erste abstimmbare Element Teil eines Resonators und das zweite abstimmbare Element Teil eines Verstärkers. Resonator und Verstärker sind miteinander verbunden. Dabei wird mittels des ersten abstimmbaren Elements die Resonanzfrequenz des Resonators eingestellt. Mit dem zweiten abstimmbaren Element wird der resonatorseitige komplexe Widerstand des Verstärkers angepasst.

Die US 4,638,264 offenbart zwar die Erweiterung des nutzbaren Frequenzbereiches mittels einer zuschaltbaren Kapazität, geht aber in keiner Weise auf die Problematik des Phasenrauschens des Abstimmelements im Resonator ein, sondern beschreibt lediglich, dass ein Rauschen des Transistors ein Schwingen des Oszillators anregt.

Das Phasenrauschen eines spannungsgesteuerten Oszillators hat maßgeblichen Einfluss auf die Qualität des Ausgangssignals eines Systems, bei dem der Oszillator eingesetzt wird. Aus diesem Grund ist man beim Entwurf von spannungsgesteuerten Oszillatoren bemüht, die Leistung des Phasenrauschens bezogen auf das Nutzsignal soweit wie möglich zu unterdrücken. Neben weiteren Einflüssen spielt die Resonatorgüte, die Bandbreite des Resonators sowie eine optimale Anschwingreserve des Oszillators für das Phasenrauschen eine maßgebliche Rolle.

Abstimmbare Oszillatoren für den Mikrowellenbereich haben üblicherweise einen mit einer Varactor-Diode abstimmbaren Resonator und einen hiermit gekoppelten Verstärker, im weiteren auch Oszillatorkern genannt. Als Verstärkungselement kommen bipolare Transistoren in Basis- oder Emitter-Schaltung zum Einsatz. Anstatt bipolare Transistoren können auch Feldeffekttransistoren ebenfalls in Gate- oder Source-Schaltung zum Einsatz kommen.

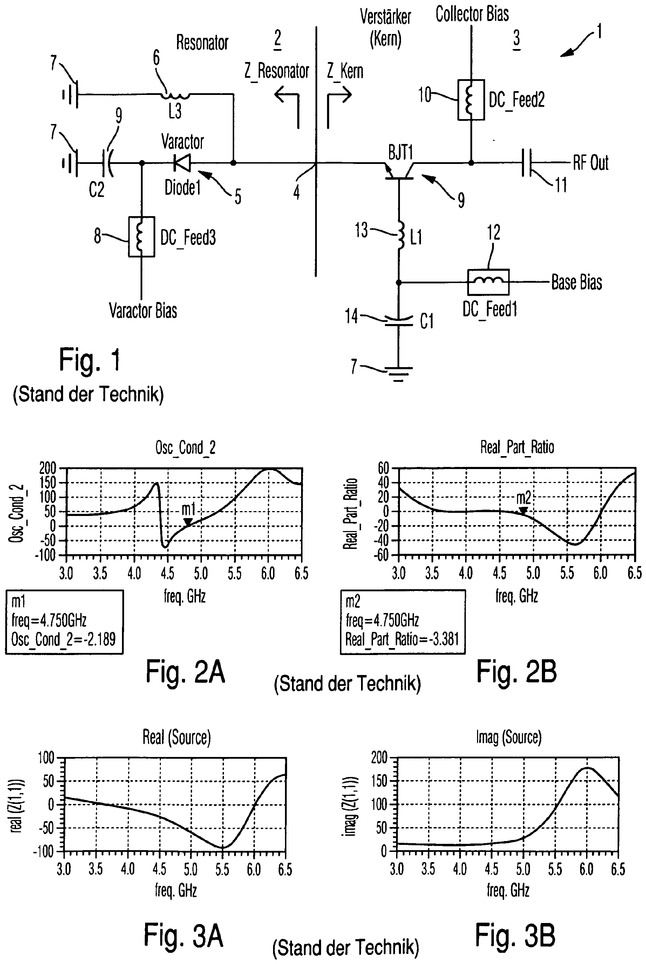

Zum Verständnis der der vorliegenden Erfindung zugrunde liegenden Problematik zeigt Fig. 1 einen bislang üblichen Oszillator 1, bestehend aus einem Resonator 2 und einem Verstärker 3, der auch als "Kern" bezeichnet wird. Der Resonator 2 und der Verstärker 3 sind an einer Koppelstelle 4 miteinander gekoppelt. Kernstück des Resonators 2 ist ein abstimmbares Element 5, welches üblicherweise durch eine Varactor-Diode, die auch als Kapazitäts-Diode bezeichnet wird, gebildet ist. Wird an die Varactor-Diode eine elektrische Spannung in Sperrrichtung angelegt, so ändert sich die Länge der Raumladungszone und somit die Kapazität der Varactor-Diode. Hierzu ist die Anode der Varactor-Diode über eine Induktivität 6 im Ausführungsbeispiel mit der Schaltungsmasse 7 verbunden und die Kathode der Varactor-Diode 5 über eine Drossel 8 mit einer gegenüber der Masse 7 positiven Abstimm-Spannung verbunden, die in Fig. 1 als "Varactor-Bias" bezeichnet ist.

Alternativ ist es natürlich auch möglich, die Kathode der Varactor-Diode 5 auf Masse zu legen und die Anode mit einer negativen Spannung gegenüber Masse zu beaufschlagen. Die Kathode der Varactor-Diode 5 ist über einen Serienkondensator 9 mit der Schaltungsmasse 7 verbunden. Die Kapazität der Varactor-Diode 5 und die Kapazität C2 des Kondensators 9 bilden zusammen mit der der Induktivität 6 mit dem Induktivitätswert L3 einen resonanten Schwingkreis.

Der Verstärker 3 umfasst ein Verstärkungselement 9. Im dargestellten Ausführungsbeispiel handelt es sich bei dem Verstärkungselement 9 um einen bipolaren Transistor, welcher in Basis-Schaltung, d. h. mit Basis zur Schaltungsmasse, betrieben wird. Alternativ kommen im Rahmen der vorliegenden Anmeldung aber auch die Emitter-Schaltung in Betracht. Anstatt eines bipolaren Transistors kann auch ein Feldeffekt-Transistor, vorzugsweise in Gate-Schaltung verwendet werden. Anstatt der Gate-Schaltung kommt hier auch eine Source-Schaltung in Betracht.

Die in Fig. 1 dargestellten Ausführungsbeispiel ist der bipolare Transistor 9 Emitter-seitig mit der Koppelstelle 4 verbunden. Der Kollektor des Transistors 9 ist über eine Drossel 10 mit der Kollektorspannung "Collector-Bias" verbunden. Gleichzeitig kann an dem Kollektor des Transistors 9 über eine Kapazität 11 die hochfrequente Ausgangsspannung RF Out abgegriffen werden. Die Basisspannung "Base-Bias" wird der Basis über eine Drossel 12 und eine Induktivität 13 zugeführt. Der Knoten zwischen der Induktivität 13 und der Drossel 12 ist über einen Kondensator 14 mit der Schaltungsmasse 7 verbunden.

Um den Oszillator 1 gemäß Fig. 1 betreiben zu können, müssen im eingeschwungenen Zustand des Oszillators 1 zwei Bedingungen erfüllt sein:
Zunächst muss im eingeschwungenen Zustand die Schleifenverstärkung des Resonantors 2 und des Verstärkers (Kerns) 3 gleich 1 sein, d. h. der Verstärker 3 muss die Verluste des Resonators 2 ausgleichen. Anders ausgedrückt muss der Quotient aus dem Realteil des komplexen Widerstands des Verstärkers von der Koppelstelle 4 aus betrachtet und des Realteils des komplexen Widerstands des Resonators 2, ebenfalls von der Koppelstelle 4 aus betrachtet -1 sein. Der komplexe Widerstand des Verstärkers (Kerns) Z_Kern, welcher sich ergibt, wenn man von der Koppelstelle 4 in den Verstärker 3 blickt und der komplexe Widerstand Z_Resonator, der sich ergibt, wenn man von der Koppelstelle 4 in den Resonator 2 blickt, sind in Fig. 1 jeweils veranschaulicht. Dass der Realteil des komplexen Widerstands Z_Kern des Verstärkers (Kerns) negativ ist, ergibt sich aus der Verstärkung (negativer Widerstand). Bei der Kleinsignalbetrachtung ist jedoch zum sicheren Anschwingen des Oszillators 1 sicherzustellen, dass auch eine ausreichende Anschwingreserve vorhanden ist, d. h. der Quotient ist deutlich kleiner (betragsmäßig größer) als -1, idealerweise ca. -3.

Die zweite Bedingung ist eine Phasenbedingung und führt dazu, dass die Summe der Imaginärteile des komplexen Widerstands des Resonators Z_Resonator und des Verstärkers Z_Kern bei der Resonanzfrequenz gleich 0 sein muss. Anschaulich betrachtet bedeutet dies, dass eine Welle, die ausgehend vom Kopplungspunkt 4 in den Resonator 2 hineinläuft, dort reflektiert wird und dann in den Verstärker 3 hineinläuft und dort ebenfalls verstärkt reflektiert wird und schließlich wieder zum Kopplungspunkt 4 gelangt, sich in ihrer Phase nur um ein ganzzahliges Vielfaches von 2π geändert haben darf (Mitkopplung), damit das System für diese Frequenz resonant ist.

In Fig. 2A ist der Imaginärteil der Summe der beiden komplexen Widerstande Z_Resonator und Z_Kern für eine bestimmte Abstimmspannung der Varactor-Diode 5 dargestellt. Daran erkennt man, dass die zweite Bedingung Im(Z_Resonator) + Im(Z_Kern) = 0 bei 4,75 GHz erfüllt ist. Wie in Fig. 2B gezeigt, ergibt sich bei der gleichen Frequenz für den Quotienten der Realteile der beiden komplexen Widerstände ein Verhältnis von -3,381, so dass eine ausreichende Anlaufreserve zur Verfügung steht.

Der Oszillator 1 soll aber über einen relativ großen Frequenzbereich betrieben werden, wobei die Resonanzfrequenz über mehrere GHz variierbar sein soll. In Fig. 3A ist der Realteil und in Fig. 3B der Imaginärteil des komplexen Widerstands Z_Kern des Verstärkers 3 dargestellt. Man erkennt für das dargestellte Beispiel bei ca. 6 GHz eine Resonanz, welche die Abstimmbandbreite signifikant bestimmt und einschränkt. Dies zeigt sich beim Abstimmen der Abstimmspannung der Varactor-Diode 5 des Resonators 2.

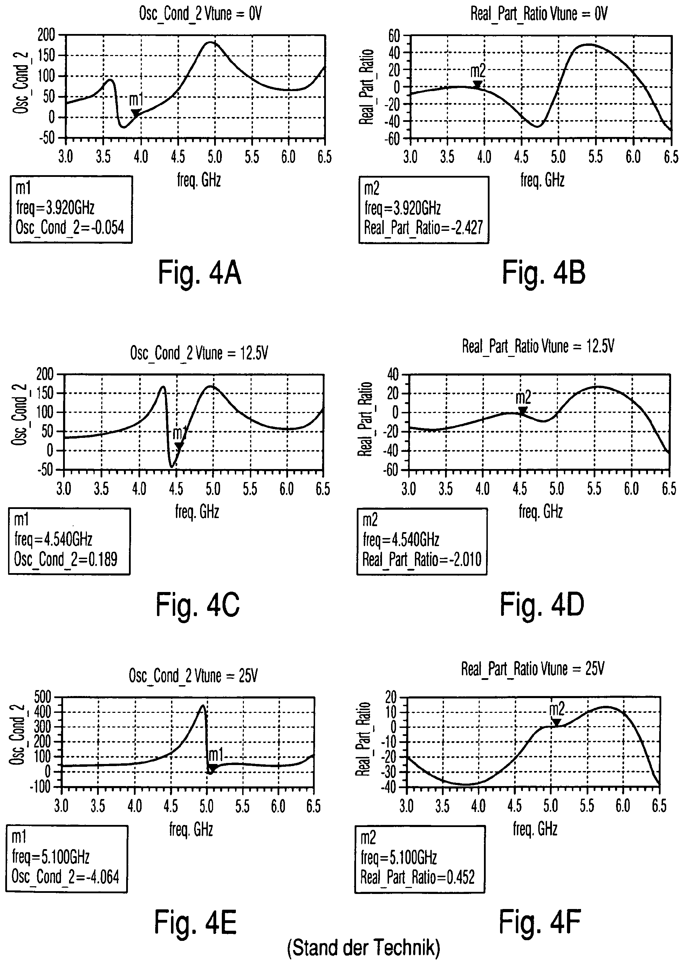

In den Fig. 4A, 4C und 4E sind die Imaginärteile der Summe der Imaginärteile der komplexen Widerstände Z_Resonator und Z_Kern für unterschiedliche Abstimmspannungen die Varactor-Diode von 0 V, 12,5 und 25 V dargestellt. In den Fig. 4B, 4D und 4F sind entsprechend die Quotienten der Realteile für die gleichen Abstimmspannungen dargestellt. Man erkennt dass sich zwar überall noch die zweite Bedingung für einen verschwindenden imaginären Teil erreichen lässt, dass aber die erste Bedingung nicht mehr überall erreicht werden kann. Beispielsweise wird sie in Fig. 4F für die Abstimmspannung 25 V nicht mehr erreicht; der Quotient ist sogar positiv. In Fig. 4D wird für die Abstimmspannung 12,5 V nur ein Quotient von -2,010 erreicht; hier sollte noch eine ausreichende Anschwingreserve vorhanden ist. Der Erfindung liegt also das Problem zugrunde, dass die Bedingungen für den Betrieb des Oszillators im Stand der Technik nur über einen relativ begrenzten Frequenzbereich erreicht werden kann.

Der Erfindung liegt daher die Aufgabe zugrunde, einen Oszillator zu schaffen, der in einem breiteren Frequenzbereich sicher betrieben werden kann.

Die Aufgabe wird durch die Merkmale des Anspruchs 1 gelöst. Die Unteransprüche enthalten vorteilhafte Weiterbildungen der Erfindung.

Erfindungsgemäß wird vorgeschlagen, in dem Verstärker ein zweites abstimmbares Element, beispielsweise eine weitere Varactor-Diode, vorzusehen, so dass der komplexe Widerstand, den der Verstärker an der Koppelstelle aufweist, frequenzabhängig veränderbar ist.

Die erfindungsgemäße Lösung hat den Vorteil, dass durch die Variation des komplexen Widerstands des Verstärkers ein weiterer Freiheitsgrad gewonnen wird, um den beiden Oszillator-Bedingungen zu genügen. Dabei kann auch für höhere Frequenzen die erste Oszillator-Bedingung, nämlich dass der Quotient aus dem Realteil des komplexen Widerstands, den der Verstärker an der Koppelstelle aufweist, zu dem Realteil des komplexen Widerstands, den der Resonator an der Koppelstelle aufweist, stets kleiner als -1 ist, erfüllt werden. Dadurch dass nicht nur der Resonator abgestimmt wird, sondern auch der Verstärker, gibt es mehrere Abstimmzustände, bei welchen die erste Oszillator-Bedingung erfüllt ist und es kann ein solcher Zustand ausgewählt werden, der eine ausreichende Gesamtverstärkung sicherstellt.

Eine ausreichende Anschwingreserve ist dabei in der Regel gegeben, wenn der Quotient der Realteile der beiden komplexen Widerstände kleiner oder gleich -1,9, bevorzugt kleiner oder gleich -3 ist (kleiner bedeutet hier im mathematischen Sinne eine betragsmäßig größere negative Zahl.
Ein weiterer Vorteil besteht im Verschieben der Resonanz im Imaginärteil des Kerns, was zu einer deutlich höheren Bandbreite führt.

Besonders bevorzugt erfolgt die Mitführung des Verstärkers durch ein Mitziehen der Rückkopplung an der Basis des vorzugsweise in einer Basis-Schaltung geschalteten Bipolar-Transistors des Verstärkers. In den Rückkopplungszweig der Basis wird vorzugsweise eine Varactor-Diode eingesetzt. Dabei befindet sich die Varactor-Diode vorzugsweise zwischen der Basis des Bipolar-Transistors und der Schaltungsmasse. Die Varactor-Diode kann aber auch an anderer Stelle als an der Basis, beispielsweise in einem speziellen Phasenschieber-Netzwerk, das emitterseitig oder kollektorseitig angeordnet ist, vorgesehen sein.

Wenn es sich bei dem Verstärkungs-Element um einen Feldeffekt-Transistor handelt, so ist dieser vorzugsweise in Gate-Schaltung geschaltet und die Varactor-Diode befindet sich zwischen dem Gate des Feldeffekt-Transistors und der Schaltungsmasse.

Vorzugsweise ist parallel zu den Resonatorvaractoren eine Schalteinrichtung vorgesehen, mittels welcher eine zu dem Resonator parallel geschaltete Zusatzkapazität zu- bzw. wegschaltbar ist. Dadurch kann bei niedrigen Frequenzen eine Zusatzkapazität parallel zu der Varactor-Diode des ersten abstimmbaren Elements geschaltet werden. Dadurch wird der Abstimmbereich in zwei Sub-Bände aufgeteilt und es ist nicht mehr nötig, die Varactor-Diode im Bereich niedriger Sperrspannung und somit hoher Kapazität zu betreiben. In diesem Bereich hat die Varactor-Diode relative große Bahn-Widerstände und trägt dabei erheblich zum Phasenrauschen des Oszillators bei. Dadurch, dass die Varactor-Diode des Resonators nicht mehr im Bereich hoher Kapazitäten betrieben werden muss, ergibt sich somit eine Verringerung des Phasenrauschens in diesem Frequenzbereich durch eine Verbesserung der Resonatorgüte.

Bei Umschaltung des Resonators in das untere Sub-Band verschieben sich jedoch die Imaginär- und Realteile des komplexen Widerstands des Resonators, so dass es Betriebspunkte geben kann, bei welchen die optimalen Anschwingbedingungen nicht mehr sicher erfüllt sind. Dies kann zum Abreisen der Oszillation führen. Durch Einfügen eines Spannungs-Offsets zwischen den Abstimmspannungen am Resonator und im Verstärker kann für beide Bandbereiche wieder ein optimaler Bereich für die Anschwingreserve und damit für das Phasenrauschen eingestellt werden.

Nachfolgend werden Ausführungsbeispiele der Erfindung unter Bezugnahme auf die Zeichnung näher erläutert. In der Zeichnung zeigen:
- Fig. 1: einen Oszillator nach dem Stand der Technik;
- Fig. 2A: die Summe der Imaginärteile der komplexen Widerstände des Resonators und des Verstärkers nach Fig. 1;
- Fig. 2B: den Quotienten des Realteils des komplexen Widerstands des Verstärkers und des Realteils des komplexen Widerstands des Resonators nach Fig. 1;
- Fig. 3A: den Realteil des komplexen Widerstands des Verstärkers nach Fig. 1;
- Fig. 3B: den Imaginärteil des komplexen Widerstands des Verstärkers nach Fig. 1;
- Fig. 4A: die Summe der Imaginärteile der komplexen Widerstände des Resonators und des Verstärkers bei einer Abstimmspannung von 0 V beim Beispiel nach Fig. 1;
- Fig. 4B: den Quotienten des Realteils des komplexen Widerstands des Verstärkers und des Realteils des komplexen Widerstands des Resonators bei einer Abstimmspannung von 0 V beim Beispiel nach Fig. 1;
- Fig. 4C: die Summe der Imaginärteile der komplexen Widerstände des Resonators und des Verstärkers bei einer Abstimmspannung von 12,5 V beim Beispiel nach Fig. 1;
- Fig. 4D: den Quotienten des Realteils des komplexen Widerstands des Verstärkers und des Realteils des komplexen Widerstands des Resonators bei einer Abstimmspannung von 12,5 V beim Beispiel nach Fig. 1;
- Fig. 4E: die Summe der Imaginärteile der komplexen Widerstände des Resonators und des Verstärkers bei einer Abstimmspannung von 25 V beim Beispiel nach Fig. 1;
- Fig. 4F: den Quotienten des Realteils des komplexen Widerstands des Verstärkers und des Realteils des komplexen Widerstands des Resonators bei einer Abstimmspannung von 25 V beim Beispiel nach Fig. 1;
- Fig. 5: ein erstes Beispiel eines nicht erfindungsgemäßen Oszillators;
- Fig. 6A: den Realteil des komplexen Widerstands des Verstärkers nach Fig. 5 bei verschiedenen Abstimmspannungen;
- Fig. 6B: den Imaginärteil des komplexen Widerstands des Verstärkers bei verschiedenen Abstimmspannungen;
- Fig. 7A: die Summe der Imaginärteile der komplexen Widerstände des Resonators und des Verstärkers bei einer Abstimmspannung von 0 V beim Beispiel nach Fig. 5;
- Fig. 7B: den Quotienten des Realteils des komplexen Widerstands des Verstärkers und des Realteils des komplexen Widerstands des Resonators bei einer Abstimmspannung von 0 V beim Beispiel nach Fig. 5;
- Fig. 7C: die Summe der Imaginärteile der komplexen Widerstände des Resonators und des Verstärkers bei einer Abstimmspannung von 12,5 V beim Beispiel nach Fig. 5;
- Fig. 7D: den Quotienten des Realteils des komplexen Widerstands des Verstärkers und des Realteils des komplexen Widerstands des Resonators bei einer Abstimmspannung von 12,5 V beim Beispiel nach Fig. 5;
- Fig. 7E: die Summe der Imaginärteile der komplexen Widerstände des Resonators und des Verstärkers bei einer Abstimmspannung von 25 V beim Beispiel nach Fig. 5;
- Fig. 7F: den Quotienten des Realteils des komplexen Widerstands des Verstärkers und des Realteils des komplexen Widerstands des Resonators bei einer Abstimmspannung von 25 V beim Beispiel nach Fig. 5;
- Fig. 8: ein zweites Beispiel eines nicht erfindungsgemäßen Oszillators;
- Fig. 9A: die Summe der Imaginärteile der komplexen Widerstände des Resonators und des Verstärkers bei einer Abstimmspannung von 0 V beim Beispiel nach Fig. 8;
- Fig. 9B: den Quotienten des Realteils des komplexen Widerstands des Verstärkers und des Realteils des komplexen Widerstands des Resonators bei einer Abstimmspannung von 0 V beim Beispiel nach Fig. 8;
- Fig. 9C: die Summe der Imaginärteile der komplexen Widerstände des Resonators und des Verstärkers bei einer Abstimmspannung von 12,5 V beim beispiel nach Fig. 8;
- Fig. 9D: den Quotienten des Realteils des komplexen Widerstands des Verstärkers und des Realteils des komplexen Widerstands des Resonators bei einer Abstimmspannung von 12,5 V beim Beispiel nach Fig. 8;
- Fig. 9E: die Summe der Imaginärteile der komplexen Widerstände des Resonators und des Verstärkers bei einer Abstimmspannung von 25 V beim Beispiel nach Fig. 8;
- Fig. 9F: den Quotienten des Realteils des komplexen Widerstands des Verstärkers und des Realteils des komplexen Widerstands des Resonators bei einer Abstimmspannung von 25 V beim Beispiel nach Fig. 8;
- Fig. 10: ein erstes Ausführungsbeispiel der Erfindung;
- Fig. 11A: die Summe der Imaginärteile der komplexen Widerstände des Resonators und des Verstärkers bei einer Abstimmspannung von 0 V beim Ausführungsbeispiel nach Fig. 10;
- Fig. 11B: den Quotienten des Realteils des komplexen Widerstands des Verstärkers und des Realteils des komplexen Widerstands des Resonators bei einer Abstimmspannung von 0 V beim Ausführungsbeispiel nach Fig. 10;
- Fig. 11C: die Summe der Imaginärteile der komplexen Widerstände des Resonators und des Verstärkers bei einer Abstimmspannung von 12,5 V beim Ausführungsbeispiel nach Fig. 10;
- Fig. 11D: den Quotienten des Realteils des komplexen Widerstands des Verstärkers und des Realteils des komplexen Widerstands des Resonators bei einer Abstimmspannung von 12,5 V beim Ausführungsbeispiel nach Fig. 10;
- Fig. 11E: die Summe der Imaginärteile der komplexen Widerstände des Resonators und des Verstärkers bei einer Abstimmspannung von 25 V beim Ausführungsbeispiel nach Fig. 10 und
- Fig. 11F: den Quotienten des Realteils des komplexen Widerstands des Verstärkers und des Realteils des komplexen Widerstands des Resonators bei einer Abstimmspannung von 25 V beim Ausführungsbeispiel nach Fig. 10.

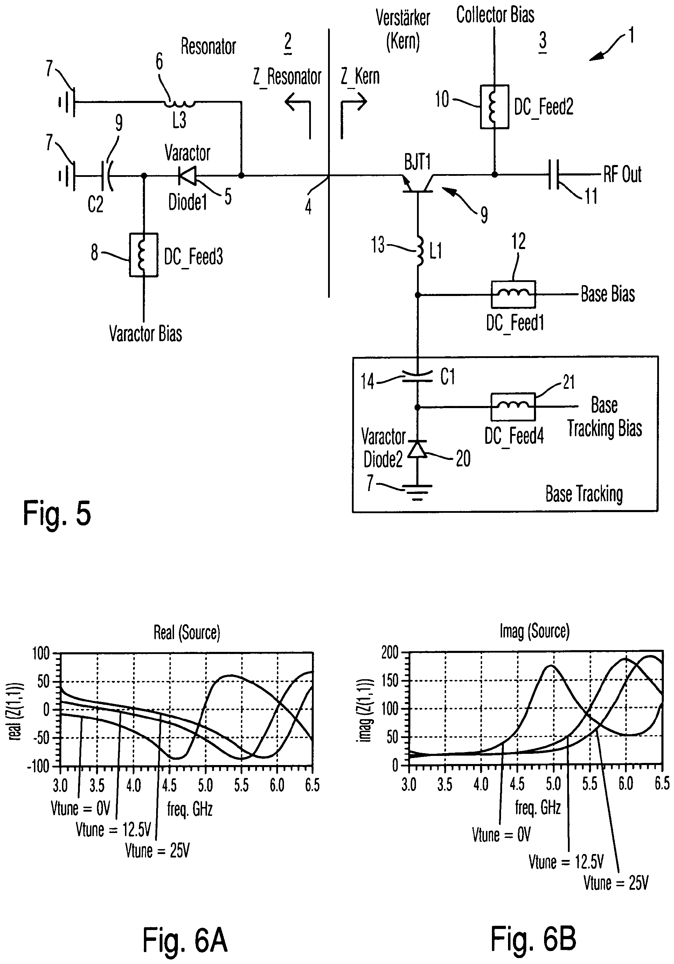

Fig. 5 zeigt ein erstes nicht erfindungsgemäßes Beispiel des Oszillators 1. Bereits anhand von Fig. 1 beschriebene Elemente sind mit übereinstimmenden Bezugszeichen versehen, so dass sich insoweit eine wiederholende Beschreibung erübrigt.

Die Besonderheit besteht darin, dass in dem Verstärker 3 ein zweites abstimmbares Element 20 vorgesehen ist, über welchem der komplexe Widerstand Z_Kern, den der Verstärker 3 an der Koppelstelle 4 aufweist, frequenzabhängig veränderbar ist. Im dargestellten Beispiel handelt es sich auch beim dem zweiten abstimmbaren Element 20 um eine Varactor-Diode (Kapazitätsdiode). Grundsätzlich kommen aber auch andere abstimmbare Elemente, beispielsweise mechanisch über einen elektrisch ansteuerbaren Aktuator verstellbare Kondensatoren oder Induktivitäten, im Rahmen der Erfindung in Betracht. Die Kapazität der zweiten Varactor-Diode 20 ist genauso wie bei der ersten Varactor-Diode 5 durch Variation der über die Drossel 21 zugeführten Sperrspannung, die in Fig. 5 als "Base Tracking Bias" bezeichnet ist, einstellbar.

Im in Fig. 5 dargestellten Beispiel ist die Kathode der zweiten Varactor-Diode 20 über die Drossel 21 mit dem positiven Pol der Spannungsquelle verbunden und die Anode steht mit der Schaltungsmasse 7 in Verbindung. Über den Kondensator 14 ist der Gleichstrom-Steuerpfad der Varactor-Diode 20 von dem Basisstromkreis des Transistors 9 getrennt, so dass sich ein relativ einfacher Aufbau ergibt. Weiterhin kann mit diesem Kondensator das Abstimmverhalten des Kerns eingestellt werden (Steilheit). Grundsätzlich ist es aber auch möglich, die Varactor-Diode 20 an anderer Stelle, beispielsweise zwischen der Induktivität 13 und dem Kondensator 14 anzuordnen und beispielsweise einen weiteren Trennkondensator zwischen der Varactor-Diode und dem Basisstromkreis vorzusehen. Das abstimmbare Element kann auch im Kollektorpfad oder im Emitterpfad des bipolaren Transistors 9 vorgesehen sein.

Fig. 6A zeigt den Realteil des komplexen Widerstands Z_Kern des Verstärkers 3, wie er sich an der Kopplungsstelle 4 ergibt. Fig. 6B zeigt entsprechend den Imaginärteil des komplexen Widerstands Z_Kern des Verstärkers 3, wie er sich an der Kopplungsstelle 4 ergibt. Es ergibt sich ein ähnlicher Verlauf in den Figuren 3A und 3B, wobei jedoch die Lage der Minima und Maxima, insbesondere des Maximums des Imaginärteils in Abhängigkeit von der an der zweiten Varactor-Diode 20 angelegten Spannung Vtune geändert werden kann. Wie sich aus Fig. 6B ergibt, liegt bei dem dargestellten Beispiel das Maximum des Imaginärteils bei ca. 4,9 GHz, wenn an die zweite Varactor-Diode 20 keine Spannung angelegt wird (Vtune = 0 V). Bei Anliegen einer Sperrspannung von 12,5 V bzw. 25 V liegt das Maximum hingegen bei 6 GHz bzw. 6,3 GHz.

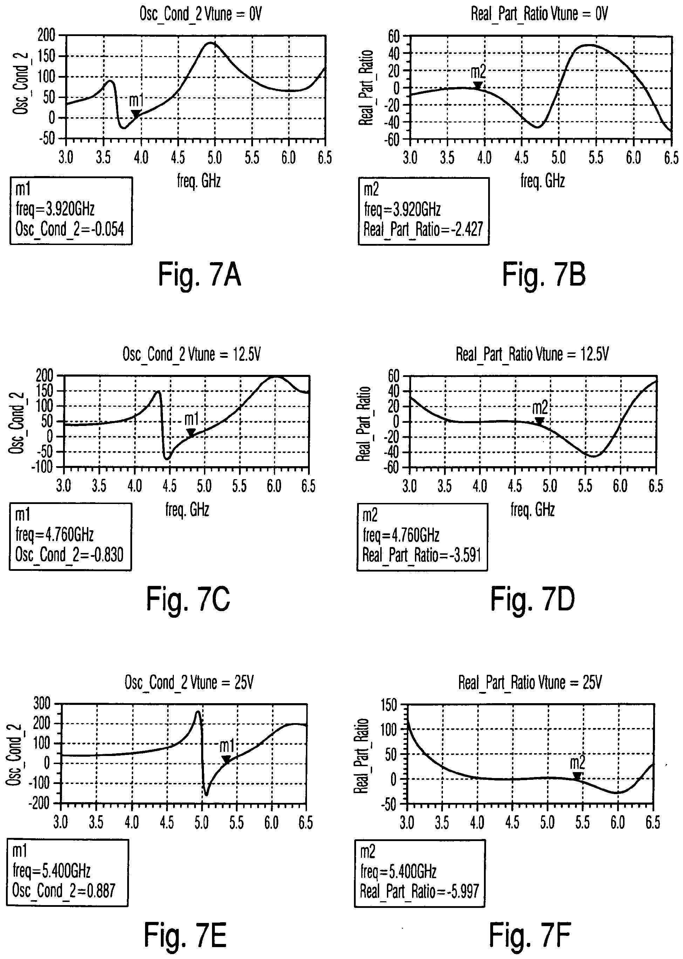

In den Fig. 7A, 7C und 7E ist der Imaginärteil der Summe der beiden komplexen Widerstände Z_Kern und Z_Resonator für unterschiedliche Abstimmspannungen Vtune von 0 V, 12,5 V und 25 V dargestellt, wobei diese Abstimmspannung Vtune jeweils an beide Varactor-Dioden 5 und 20 in gleicher Weise angelegt wird. Die Fig. 7B, 7D und 7F zeigen das Verhältnis der Realteile der komplexen Widerstände Z_Kern und Z_Resonator für die gleichen Abstimmspannungen Vtune von 0 V, 12,5 V und 25 V. Wie man erkennt, liegt das Verhältnis der Realteile und somit die Gesamtverstärkung des Systems zwischen -2,427 bei Vtune = 0 V bis -5,997 bei Vtune = 25 V. Über die gesamte Bandbreite zwischen 3,920 GHz bis 5,400 GHz steht somit eine ausreichende Anschwingreserve zur Verfügung. Der Abstimmbereich, in welchem der Oszillator 1 betrieben werden kann, ist daher wesentlich größer, als beim Oszillator nach dem Stand der Technik.

Der in Fig. 1 dargestellte Oszillator nach dem Stand der Technik hat neben dem bereits beschriebenen Problem der reduzierten Abstimmbandbreite bei niedrigen Abstimmfrequenzen ein relativ hohes Phasenrauschen. Bei niedrigen Abstimmspannungen, d. h. großen Kapazitäten der Varactor-Diode 5, ergibt sich eine relativ kleine Raumladungszone und somit ein relativ großer Bahnwiderstand der Dioden. Bei niedriger Güte der eingesetzten Varactor-Dioden können diese Bahnwiderstände zu einem nicht akzeptablen hohen Phasenrauschen führen.

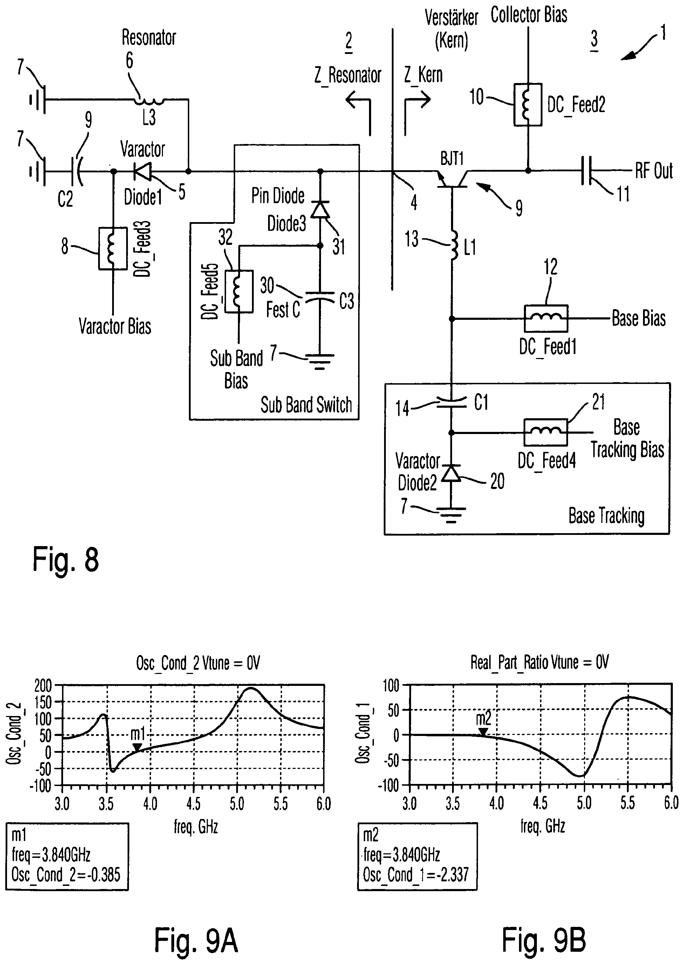

Um auch dieses Problem zu lösen, wird das in Fig. 8 dargestellte Beispiel vorgeschlagen. Auch hier sind bereits anhand von Fig. 5 beschriebene Elemente mit übereinstimmenden Bezugszeichen versehen, so dass sich insoweit eine wiederholende Beschreibung erübrigt.

Bei dem in Fig. 8 gezeigten Beispiel wird der Varactor-Diode 5 über ein Schaltelement 31 ein Kondensator 30 mit fester Kapazität C3 bei niedrigen Frequenzen parallel geschaltet. Das Schaltelement 31 kann beispielsweise als PIN-Diode ausgebildet sein, deren Anode im Beispiel über eine Drossel 32 mit der Schaltspannung "Sub Band Bias" verbunden ist. Dabei ist der Kondensator 30 nur dann parallel zu der Varactor-Diode 5 geschaltet, wenn die PIN-Diode 31 durch Anliegen der Spannung "Sub Band Bias" durchgeschaltet ist. Dadurch kann der Abstimmbereich in zwei Sub-Bänder aufgeteilt werden. In einem oberen Sub-Band bei höheren Frequenzen wird das Schaltelement 31 nicht geschaltet. In einem unteren Sub-Band bei niedrigeren Frequenzen wird die PIN-Diode geschaltet, um den Kondensator 30 parallel zu der Varactor-Diode 5 zu schalten.

Durch die im unteren Sub-Band eingeschaltete Fest-Kapazität C3 verschiebt sich die Resonanzfrequenz zu erheblich niedrigeren Werten. Die gewünschte untere Frequenzgrenze des Oszillators 1 wird daher bei dem Beispiel nach Fig. 8 bei einer Abstimmspannung von ca. 7,5 V anstelle von ca. 2 V bei dem Beispiel nach Fig. 1 bzw. dem Beispiel nach Fig. 5 erreicht. Bei einer Abstimmspannung von 7,5 V weist die Varactor-Diode 5 jedoch eine erheblich besser Güte und ein erheblich niedrigeres Phasenrauschen auf, als bei 2 V. Die Verbesserung der Resonatorgüte, sowie die Verkleinerung der Bandbreite des unteren Sub-Bandes führen damit zur Verbesserung des Phasenrauschens im kritischen unteren Frequenzbereich. Die Realisierung der Umschaltung mittels einer PIN-Diode führt nur zu einem unerheblichen Mehraufwand.

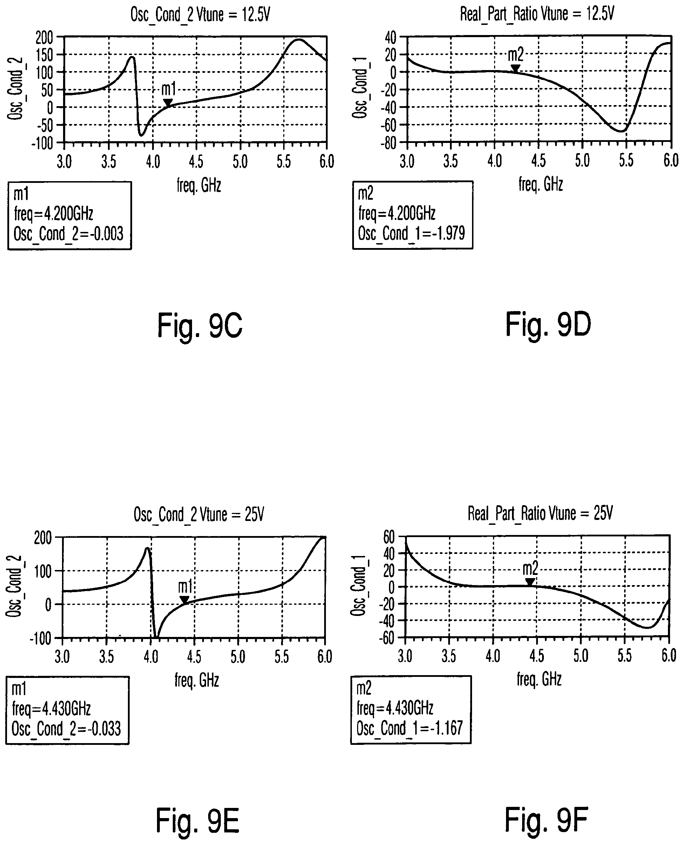

Die Fig. 9A, 9C und 9E zeigen jeweils den Imaginärteil von Z_Kern + Z_Resonator für die gleichen Abstimmspannungen Vtune von 0 V, 12,5 V und 25 V wie die Fig. 7A, 7C und 7E. Entsprechend zeigen die Figuren 9B, 9D und 9F das Verhältnis der Realteile von Z_Kern zu Z_Resonator für die gleichen Abstimmspannungen analog zu den Fig. 7B, 7D und 7F. Durch Vergleich der Darstellung zu Fig. 9 mit der Darstellung zu Fig. 7 erkennt man, dass durch die Umschaltung des Resonators die Imaginär- und Realteile des Resonators 2 und des Verstärkers 3 sich gegeneinander verschieben, so dass die optimalen Anschwingbedingungen nicht mehr überall erfüllt sind. Bei einer hohen Abstimm-Spannung Vtune ist nur noch eine minimale Anschwingreserve vorhanden. Dies führt nicht zu optimalem Phasenrauschen und kann im Extremfall sogar zum Abreißen der Oszillation führen.

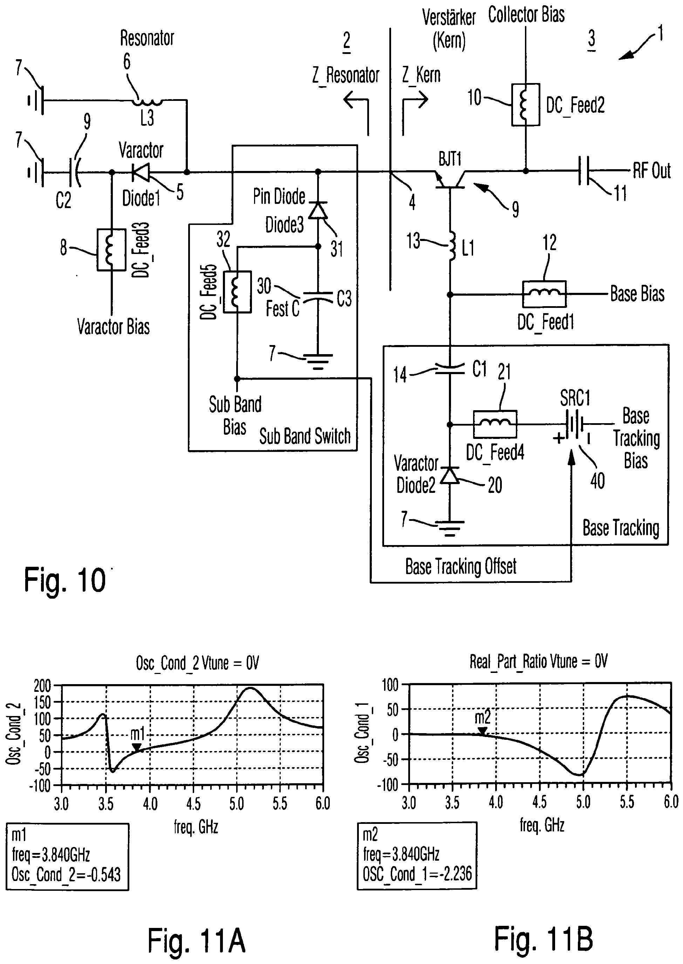

Um dies zu vermeiden, wird entsprechend dem in Fig. 10 dargestellten erfindungsgemäßen Ausführungsbeispiel vorgeschlagen, an das Abstimmelement 5 des Resonators 2 und an das Abstimmelement 20 des Verstärkers 3 nicht die gleiche Abstimmspannung anzulegen, sondern zwischen beiden Abstimmspannungen eine Versatzspannung (Spannungs-Offset) einzufügen. Die Einfügung der Versatzspannung erfolgt aber nur im unteren Sub-Band bei niedrigen Frequenzen.

Bei dem in Fig. 10 dargestellten Ausführungsbeispiel sind bereits anhand von Fig. 8 beschriebene Elemente mit übereinstimmenden Bezugszeichen versehen, so dass sich insoweit eine wiederholende Beschreibung erübrigt.

Bei dem in Fig. 10 dargestellten Ausführungsbeispiel ist eine zusätzliche Spannungsquelle 40 vorgesehen, die mit der Abstimm-Spannung "Base Tracking Bias" zur Abstimmung des zweiten Abstimmelements 20 in Serie geschaltet ist. Die Spannungsquelle kann zwischen den Polen "+" und "-" an beliebiger Stelle abgegriffen werden. Diese Versatzspannung "Base Tracking Offset" wird zusätzlich zu der Abstimmspannung "Base Tracking Bias" eingespeist. Sie addiert sich somit zu der Abstimm-Spannung "Base Tracking Bias" des zweiten Abstimm-Elements 20. Der Vorteil der gleichzeitigen Einspeisung mit dem Einschalten des Schaltelements 31 liegt darin, dass die Versatzspannung nur dann zum zweiten Abstimm-Element 20 geführt wird, wenn das Schaltelement 31 in das untere Sub-Band schaltet, d. h. bei niedrigen Frequenzen.

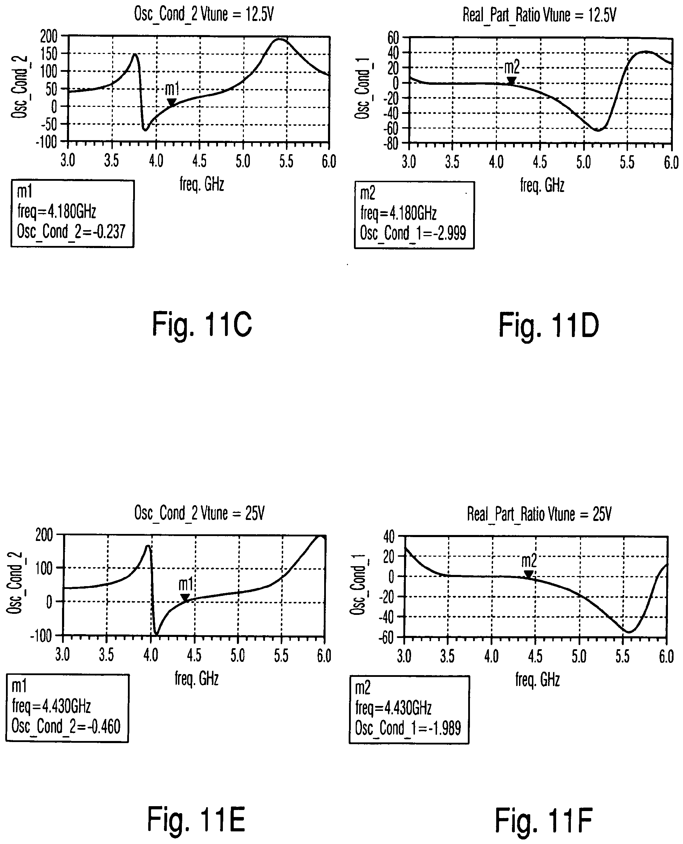

Die Fig. 11A, 11C und 11E zeigen in analoger Darstellung zu den Fig. 9A, 9C und 9E die Summe der Imaginärteile der komplexen Widerstände Z_Kern und Z_Resonator. Die Fig. 11B, 11D und 11F zeigen in analoger Darstellung zu den Fig. 9B, 9D und 9F das Verhältnis der Realteile der komplexen Widerstände Z_Kern und Z_Resonator. Ein Vergleich der Fig. 11B, 11D und 11F mit den Fig. 9B, 9D und 9F macht deutlich, dass über den gesamten Abstimmbereich hinweg eine ausreichende Anschwingreserve erzielt wird.

Die Erfindung ist nicht auf das dargestellte Ausführungsbeispiel beschränkt. Es können auch andere Abstimmelemente als Varactor-Dioden, beispielsweise mechanisch verstellbare Kapazitäten oder Induktivitäten zum Einsatz kommen. Anstatt eines Bipolar-Transistors kann auch ein Feldeffekttransistor eingesetzt werden. Die Versatzspannung muss nicht notwendiger Weise durch einen separate Spannungsquelle erzeugt werden. Die Spannungen könnten auch aus einer gemeinsamen Spannungsquelle über einen einfachen Widerstands-Spannungsteiler abgeleitet werden.

## Patentansprüche

1. Oszillator (1) mit
einem Resonator (2) mit zumindest einem ersten abstimmbaren Element (5), mit welchem die Resonanzfrequenz des Resonators (2) veränderbar ist, und
einem mit dem Resonator (2) an einer Koppelstelle (4) verbundenen Verstärker (3), der ein Verstärkungselement (9) aufweist,
wobei der Verstärker (3) ein zweites abstimmbares Element (20) aufweist, über welchen der komplexe Widerstand (Z_Kern), den der Verstärker (3) an der Koppelstelle (4) aufweist, frequenzabhängig veränderbar ist, und
wobei das erste abstimmbare Element (5) des Resonators (2) und das zweite abstimmbare Element (20) des Verstärkers (3) versetzt zueinander abgestimmt werden,
**dadurch gekennzeichnet,**
**dass** eine Schalteinrichtung (31) vorgesehen ist, welche bei niedrigen Resonanzfrequenzen des Resonators (2) eine Zusatzkapazität (30) parallel zu dem ersten abstimmbaren Element (5) schaltet,
wobei eine Spannungsquelle (40) eine Versatzspannung erzeugt, mit der das zweite abstimmbare Element (20) je nach Schaltstellung der Schalteinrichtung (31) zusätzlich beaufschlagbar ist, wobei die zusätzliche Beaufschlagung mit der Versatzspannung gleichzeitig mit der Parallelschaltung der Zusatzkapazität (30) zu dem ersten abstimmbaren Element (5) erfolgt.

2. Oszillator nach Anspruch 1,
**dadurch gekennzeichnet,**
**dass** die Änderung des komplexen Widerstands (Z_Kern), den der Verstärker (3) an der Koppelstelle (4) aufweist, mittels des zweiten abstimmbaren Elements (20) derart erfolgt, dass der Quotient (Re(Z_Kern)/Re(Z_Resonator)) aus dem Realteil des komplexen Widerstands (Z_Kern), den der Verstärker (3) an der Koppelstelle (4) aufweist, zu dem Realteil des komplexen Widerstands (Z_Resonator), den der Resonator (2) an der Koppelstelle (4) aufweist, stets kleiner als -1 ist.

3. Oszillator nach Anspruch 2,
**dadurch gekennzeichnet,**
**dass** der Quotient (Re(Z_Kern)/Re(Z_Resonator)) aus dem Realteil des komplexen Widerstands (Z_Kern), den der Verstärker (3) an der Koppelstelle (4) aufweist, zu dem Realteil des komplexen Widerstands (Z_Resonator), den der Resonator (2) an der Koppelstelle (4) aufweist, stets kleiner oder gleich als -1, bevorzugt kleiner oder gleich als -3, ist, um eine Anschwingreserve sicherzustellen.

4. Oszillator nach einem der Ansprüche 1 bis 3,
**dadurch gekennzeichnet,**
**dass** das Verstärkungselement (9) ein Bipolar-Transistor ist.

5. Oszillator nach Anspruch 4,
**dadurch gekennzeichnet,**
**dass** sich der Bipolar-Transistor (9) in Basisschaltung befindet,
**dass** das zweite abstimmbare Element (20) eine Varaktor-Diode (20) ist und
**dass** sich die Varactor-Diode des zweiten abstimmbaren Elements (20) zwischen der Basis des Bipolar-Transistors (9) und der Schaltungsmasse (7) befindet.

6. Oszillator nach einem der Ansprüche 1 bis 3,
**dadurch gekennzeichnet,**
**dass** das Verstärkungselement (9) ein Feldeffekt-Transistor ist.

7. Oszillator nach Anspruch 6,
**dadurch gekennzeichnet,**
**dass** sich der Feldeffekt-Transistor in Gateschaltung befindet,
**dass** das zweite abstimmbare Element (20) eine Varactor-Diode ist und
**dass** sich die Varactor-Diode des zweiten abstimmbaren Elements (20) zwischen dem Gate des Feldeffekt-Transistors (9) und der Schaltungsmasse (7) befindet.

8. Oszillator nach Anspruch 1,
**dadurch gekennzeichnet,**
**dass** das erste abstimmbare Element (5) eine Varactor-Diode ist.

## Claims

1. Oscillator (1) comprising
a resonator (2) comprising at least one first tuneable element (5), which can be used to change the resonant frequency of the resonator (2),
and
an amplifier (3), which is connected to the resonator (2) at a coupling point (4) and which has an amplifying element (9),
wherein the amplifier (3) has a second tuneable element (20), by means of which the complex resistance (Z_core) that the amplifier (3) has at the coupling point (4) can be changed in a manner dependent on frequency, and wherein the first tuneable element (5) of the resonator (2) and the second tuneable element (20) of the amplifier (3) are tuned in a manner offset with respect to one another,
**characterized in that**
a switching device (31) is provided, which switching device connects an additional capacitance (30) in parallel with the first tuneable element (5) in the case of low resonant frequencies of the resonator (2), wherein a voltage source (40) generates an offset voltage, which can additionally be supplied to the second tuneable element (20) depending on the switching position of the switching device (31), wherein the additional supply of the offset voltage takes place at the same time as the parallel connection of the additional capacitance (30) with the first tuneable element (5).

2. Oscillator according to Claim 1,
**characterized in that**
the complex resistance (Z_core) that the amplifier (3) has at the coupling point (4) is changed by means of the second tuneable element (20) in such a way that the quotient (Re(Z_core)/Re(Z_resonator)) of the real part of the complex resistance (Z_core) that the amplifier (3) has at the coupling point (4) by the real part of the complex resistance (Z_resonator) that the resonator (2) has at the coupling point (4) is always less than - 1.

3. Oscillator according to Claim 2,
**characterized in that**
the quotient (Re(Z_core)/Re(Z_resonator)) of the real part of the complex resistance (Z_core) that the amplifier (3) has at the coupling point (4) by the real part of the complex resistance (Z_resonator) that the resonator (2) has at the coupling point (4) is always less than or equal to -1, preferably less than or equal to -3, in order to ensure an oscillation reserve.

4. Oscillator according to one of Claims 1 to 3,
**characterized in that**
the amplifying element (9) is a bipolar transistor.

5. Oscillator according to Claim 4,
**characterized in that** the bipolar transistor (9) is in common-base connection,
**in that** the second tuneable element (20) is a varactor diode (20) and
**in that** the varactor diode of the second tuneable element (20) is located between the base of the bipolar transistor (9) and the circuit earth (7).

6. Oscillator according to one of Claims 1 to 3,
**characterized in that**
the amplifying element (9) is a field-effect transistor.

7. Oscillator according to Claim 6,
**characterized in that**
the field-effect transistor is in common-gate connection,
**in that** the second tuneable element (20) is a varactor diode and
**in that** the varactor diode of the second tuneable element (20) is located between the gate of the field-effect transistor (9) and the circuit earth (7).

8. Oscillator according to Claim 1,
**characterized in that**
the first tuneable element (5) is a varactor diode.

## Revendications

1. Oscillateur (1) comprenant
un résonateur (2) pourvu d'au moins un premier élément accordable (5), au moyen duquel la fréquence de résonance du résonateur (2) peut être modifiée, et
un amplificateur (3) qui est relié au résonateur (2) en un point de couplage (4) et qui comprend un élément d'amplification (9),
dans lequel l'amplificateur (3) comprend un deuxième élément accordable (20) par l'intermédiaire duquel la résistance complexe (Z_Kern) que l'amplificateur (3) présente au point de couplage (4) peut être modifiée en fonction de la fréquence, et
dans lequel le premier élément accordable (5) du résonateur (2) et le deuxième élément accordable (20) de l'amplificateur (3) sont accordés en décalage l'un de l'autre,
**caractérisé**
**en ce qu'**un dispositif de commutation (31) est prévu, lequel, dans le cas de basses fréquences de résonance du résonateur (2), commute une capacité supplémentaire (30) parallèlement au premier élément accordable (5),
dans lequel une source de tension (40) génère une tension de décalage, à laquelle le deuxième élément accordable (20) peut être soumis en plus en fonction de la position de commutation du dispositif de commutation (31), dans lequel la soumission supplémentaire à la tension de décalage est réalisée en même temps que la commutation de la capacité supplémentaire (30) parallèlement au premier élément accordable (5).

2. Oscillateur selon la revendication 1,
**caractérisé**
**en ce que** la modification de la résistance complexe (Z_Kern), que l'amplificateur (3) présente au point de couplage (4), est réalisée au moyen du deuxième élément accordable (20) de telle manière que le quotient (Re(Z_Kern)/Re(Z_Resonator)) de la composante réelle de la résistance complexe (Z_Kern), que l'amplificateur (3) présente au point de couplage (4), sur la composante réelle de la résistance complexe (Z_Resonator), que le résonateur (2) présente au point de couplage (4), est constamment inférieur à -1.

3. Oscillateur (1) selon la revendication 2,
**caractérisé**
**en ce que** le quotient (Re(Z_Kern)/Re(Z_Resonator)) de la composante réelle de la résistance complexe (Z_Kern), que l'amplificateur (3) présente au point de couplage (4), sur la composante réelle de la résistance complexe (Z_Resonator), que le résonateur (2) présente au point de couplage (4), est constamment inférieur ou égal à -1, de préférence inférieur ou égal à -3, afin de garantir une réserve de démarrage.

4. Oscillateur selon l'une quelconque des revendications 1 à 3,
**caractérisé**
**en ce que** l'élément d'amplification (9) est un transistor bipolaire.

5. Oscillateur selon la revendication 4,
**caractérisé**
**en ce que** le transistor bipolaire (9) se situe dans la commutation de base,
**en ce que** le deuxième élément accordable (20) est une diode varicap (20) et
**en ce que** la diode varicap du deuxième élément accordable (20) se situe entre la base du transistor bipolaire (9) et la masse de commutation (7).

6. Oscillateur selon l'une quelconque des revendications 1 à 3,
**caractérisé**
**en ce que** l'élément d'amplification (9) est un transistor à effet de champ.

7. Oscillateur selon la revendication 6,
**caractérisé**
**en ce que** le transistor à effet de champ se situe en commutation de grille,
**en ce que** le deuxième élément accordable (20) est une diode varicap et
**en ce que** la diode varicap du deuxième élément accordable (20) se situe entre la grille du transistor à effet de champ (9) et la masse de commutation (7).

8. Oscillateur selon la revendication 1,
**caractérisé**
**en ce que** le premier élément accordable (5) est une diode varicap.
